# EUROPEAN PATENT APPLICATION

(11) **EP 4 404 273 A1**
(43) Date of publication of application: **24.07.2024**
(21) Application number: 22929666.0
(22) Date of filing: 28.12.2022
(51) Int. Cl.: H01L 29/78, H01L 21/336

(54) **SIC MOSFET AND PREPARATION METHOD THEREFOR, AND INTEGRATED CIRCUIT**

(30) Priority: 02.03.2022 CN 202210206634
(71) Applicant: Huawei Digital Power Technologies Co., Ltd., Shenzhen, Guangdong 518043 (CN)
(72) Inventor: YANG, Wentao, Shenzhen, Guangdong 518043 (CN); DAI, Loucheng, Shenzhen, Guangdong 518043 (CN); ZHANG, Huiyuan, Shenzhen, Guangdong 518043 (CN); ZHAO, Qian, Shenzhen, Guangdong 518043 (CN); NING, Runtao, Shenzhen, Guangdong 518043 (CN)
(74) Representative: Isarpatent
(86) International application number: PCT/CN2022/142808
(87) International publication number: WO 2023/165242

(57) **Abstract**

This application discloses a SiC MOSFET, a SiC MOSFET preparation method, and an integrated circuit. In the SiC MOSFET, a gate electrode is located on two sides of a fin-shaped channel layer. Disposing the gate electrode on the two sides of the fin-shaped channel layer is conducive to reducing a width of the fin-shaped channel layer. This is favorable for global inversion of the fin-shaped channel layer, thereby forming a large carrier path in the fin-shaped channel layer. In this way, most carriers in the SiC MOSFET flow through an electron path formed in the fin-shaped channel layer, so that a quantity of carriers that flow on an edge of a gate oxide layer is reduced, thereby greatly improving channel mobility and also improving reliability of the gate oxide layer.

## Description

### CROSS-REFERENCE TO RELATED APPLICATIONS

This application claims priority to Chinese Patent Application No. 202210206634.7, filed with the China National Intellectual Property Administration on March 02, 2022 and entitled "SIC MOSFET, SIC MOSFET PREPARATION METHOD, AND INTEGRATED CIRCUIT", which is incorporated herein by reference in its entirety.

### TECHNICAL FIELD

This application relates to the field of semiconductor technologies, and in particular, to a SiC MOSFET, a SiC MOSFET preparation method, and an integrated circuit.

### BACKGROUND

As a next-generation wide bandgap semiconductor material, silicon carbide (SiC) has excellent performance in the field of power semiconductors, and is the cutting edge and future direction of development of power semiconductor devices. Compared with gallium arsenide and silicon, silicon carbide has overwhelming properties in the case of high pressure and high temperature. SiC is a chemical compound semiconductor material that includes silicon (Si) and carbon (C), and has many excellent characteristics, such as a large band gap, a high breakdown electric field strength, a high thermal conductivity, a high saturation velocity, and a high maximum operating temperature. These characteristics enable a silicon carbide electronic device to work in an environment with a high voltage, high calorific value, and high frequency. Compared with an insulated gate bipolar transistor (Insulated Gate Bipolar Transistor, IGBT) made of Si, a metal-oxide-semiconductor field-effect transistor (Metal-Oxide-Semiconductor Field-Effect Transistor, MOSFET) made of SiC is characterized by a smaller size, lower power consumption, and an excellent thermal conductivity property while providing the same power.

Preparation of a gate oxide layer is a key step in production of a SiC MOSFET. At present, a commonly used method is to directly perform high-temperature thermal oxidation on a SiC epitaxial wafer, to form a silicon dioxide gate oxide layer on a surface of the SiC epitaxial wafer. However, numerous interface states exist at a SiC/SiO₂ interface (for example, Si- and C-dangling bonds at the interface, a C-related defect, and an oxide defect near the interface). An interface trap traps carriers in an inversion layer, causing a current density of the device to decrease. Moreover, the trapped carriers generate Coulomb scattering on free carriers in a channel, resulting in low channel mobility and compromising a conduction characteristic of the device. Although nitridation processing may be performed on the interface through subsequent nitrogen and oxygen annealing after the oxidation to improve the channel mobility, the channel mobility is still far lower than that of a silicon carbide body material.

### SUMMARY

This application provides a SiC MOSFET, a SiC MOSFET preparation method, and an integrated circuit, to improve channel mobility of the SiC MOSFET.

According to a first aspect, this application provides a SiC MOSFET. The SiC MOSFET may include a SiC semiconductor substrate, a drift layer, a fin-shaped channel layer (namely a well region), a source region, a gate electrode, a gate oxide layer, a first insulated isolating layer, a second insulated isolating layer, a source electrode, and a drain electrode. The drift layer is located on the SiC semiconductor substrate, the fin-shaped channel layer is located on the drift layer, the source region is located on the fin-shaped channel layer, and the first insulated isolating layer is located on a portion that is of the drift layer and that is not covered by the fin-shaped channel layer. As the fin-shaped channel layer and the source region are of a stacking structure, the gate electrode is located on the first insulated isolating layer and is located on two sides of the stacking structure, and the gate oxide layer is located between the gate electrode and the stacking structure. The second insulated isolating layer covers an external side wall and an upper surface of the gate electrode. The source electrode covers the first insulated isolating layer, the second insulated isolating layer, and the source region. The drain electrode is located on a side that is of the SiC semiconductor substrate and that is away from the drift layer. The first insulated isolating layer is configured to isolate the gate electrode and the drift layer. The gate oxide layer is configured to isolate the gate electrode and the fin-shaped channel layer, and is configured to isolate the gate electrode and the source region. The second insulated isolating layer is configured to isolate the gate electrode and the source electrode.

In this application, the fin-shaped channel layer means that the channel layer is of a strip shape, and the gate electrode is located on two sides of the fin-shaped channel layer. Therefore, the SiC MOSFET is a fin field-effect transistor (Fin Field-Effect Transistor, Fin FET). Disposing the gate electrode on the two sides of the fin-shaped channel layer is conducive to reducing a width of the fin-shaped channel layer (namely a distance between two gate oxide layers on the two sides of the fin-shaped channel layer). This is favorable for global inversion of the fin-shaped channel layer, thereby forming a large carrier path in the fin-shaped channel layer. In this way, most carriers in the SiC MOSFET flow through an electron path formed in the fin-shaped channel layer, so that a quantity of carriers that flow on an edge of the gate oxide layer is reduced, thereby greatly improving channel mobility and also improving reliability of the gate oxide layer.

The SiC MOSFET provided in this embodiment of this application may be an NMOS transistor, or may be a PMOS transistor. This is not limited herein. When the SiC MOSFET is an NMOS transistor, the SiC semiconductor substrate may be an N++ region and serves as a drain region, the drift layer may be an N+ region and mainly serves to bear high voltage, the source region may be an N++ region, and the fin-shaped channel layer may be a P region, namely a P-well. A P-well is a region that is on an N-type semiconductor layer and that is doped with a P-type impurity of a density high enough to neutralize the N-type semiconductor layer and make the N-type semiconductor layer have a P-type characteristic. When the SiC MOSFET is a PMOS transistor, the SiC semiconductor substrate may be a P++ region and serves as a drain region, the drift layer may be a P+ region and mainly serves to bear high voltage, the source region may be a P++ region, and the fin-shaped channel layer may be an N region, namely an N-well. An N-well is a region that is on a P-type semiconductor layer and that is doped with an N-type impurity of a density high enough to neutralize the P-type semiconductor layer and make the P-type semiconductor layer have an N-type characteristic. During specific implementation, the SiC MOSFET is generally an NMOS transistor because hole mobility is lower than electron mobility. This is not limited herein.

During specific implementation, two types of carriers exist in a semiconductor, namely holes in a valence band and electrons in a conduction band. A semiconductor that mainly uses electrons for conduction is referred to as an N-type semiconductor, and a semiconductor that mainly uses holes for conduction is referred to as a P-type semiconductor. It should be noted that in this application, in a layer and region prefixed with N or P, a majority of carriers are electrons or holes, respectively. In addition, a plus sign "+" following N or P indicates that the region or layer has a higher doping density than a layer or region not marked with a plus sign "+", and a larger quantity of plus signs "+" indicates a higher doping density. Ns or Ps followed by the same quantity of plus signs "+" mean that the regions or layers have similar doping densities, and do not necessarily have the same doping density.

In this application, an N-type semiconductor region is mainly doped with an N-type impurity, such as phosphorus (P) or nitrogen (N). A P-type semiconductor region is mainly doped with a P-type impurity, such as aluminum (Al), boron (B), gallium (Ga), or beryllium (Be).

For example, the SiC MOSFET may further include a floating region that is located on the drift layer and that is separately located on the two sides of the fin-shaped channel layer. In this way, an electric field strength beneath the gate oxide layer can be weakened, thereby protecting the gate oxide layer and greatly improving gate reliability of the device.

During specific implementation, when the SiC MOSFET is an NMOS transistor, the floating region is a P-type semiconductor region. When the SiC MOSFET is a PMOS transistor, the floating region is an N-type semiconductor region. A doping density of the floating region is generally lower than a doping density of the fin-shaped channel layer.

Further, to implement reverse parallel connection of a flyback diode inside the device, the SiC MOSFET may further include: a groove that is located on the two sides of the fin-shaped channel layer and that penetrates through the first insulated isolating layer and a part of the floating region; and an ohmic contact portion that is padded in the groove. The source electrode is electrically connected to the floating region through the ohmic contact portion.

In this application, the ohmic contact portion may be formed by using any material that can form ohmic contact with the floating region. This is not limited herein.

In this application, to avoid a bipolar degradation effect for the SiC MOSFET, a schottky barrier diode is integrated inside the SiC MOSFET, to improve a reverse conduction characteristic and a switching characteristic. For example, in the SiC MOSFET, at least two spaced floating regions are separately disposed on the two sides of the fin-shaped channel layer. The SiC MOSFET may further include: a groove that is located on the two sides of the fin-shaped channel layer and that penetrates through the first insulated isolating layer and a part of the drift layer, where the groove is located between adjacent floating regions; and a schottky contact portion that is padded in the groove.

During specific implementation, the schottky contact portion may be formed by using any material that can form schottky contact with the drift layer. This is not limited herein. For example, the schottky contact portion may be formed by using alloy. This is not limited herein.

During specific implementation, a material of the gate electrode in this application may be a polycrystalline silicon material, or may be another material that has a good electric conduction characteristic, such as metal. This is not limited herein.

According to a second aspect, this application provides a SiC MOSFET preparation method. The preparation method may include: forming a drift layer on a SiC semiconductor substrate through epitaxy; forming a fin-shaped channel layer on the drift layer and a source region located on the fin-shaped channel layer; as the fin-shaped channel layer and the source region are of a stacking structure, separately performing thermal oxidation processing on side walls on two sides of the stacking structure to form a gate oxide layer; performing thermal oxidation processing on an exposed surface of the drift layer to form a first insulated isolating layer; forming a gate electrode on a side that is of each gate oxide layer and that is away from the stacking structure; forming, through deposition, a second insulated isolating layer that covers an external side wall and an upper surface of the gate electrode; forming, through deposition, a source electrode that covers the first insulated isolating layer, the second insulated isolating layer, and the source region; and forming, through deposition, a drain electrode on a side that is of the SiC semiconductor substrate and that is away from the drift layer.

Optionally, to prevent an upper surface of the source region from oxidation when the gate oxide layer is formed, in this application, the forming a fin-shaped channel layer on the drift layer and a source region located on the fin-shaped channel layer may include: growing a channel layer on the drift layer through epitaxy; performing ion injection on a region that is of the channel layer and that is close to a surface, to form a source region; forming a nitride layer on the channel layer; and etching on the channel layer and the nitride layer to form the fin-shaped channel layer and the source region located on the fin-shaped channel layer, and retaining the nitride layer located on the source region. After an isolating oxide layer that covers the external side wall and the upper surface of the gate electrode and an upper surface of the drift layer is formed through deposition, the nitride layer located on the source region further needs to be removed.

In a feasible implementation, before the separately performing thermal oxidation processing on side walls on two sides of the stacking structure to form a gate oxide layer, the method further includes: forming, through deposition, an oxide protection layer that covers a surface and a side wall of the stacking structure; injecting ions to the drift layer by using the oxide protection layer as an ion injection mask layer, to separately form a floating region on two sides of the fin-shaped channel layer; and removing the oxide protection layer.

Further, after the forming, through deposition, a second insulated isolating layer that covers an external side wall and an upper surface of the gate electrode, the method may further include: forming a groove that penetrates through the first insulated isolating layer and a part of the floating region; and padding an ohmic contact portion in the groove.

In another feasible implementation, before the separately performing thermal oxidation processing on side walls on two sides of the stacking structure to form a gate oxide layer, the method further includes: forming, through deposition, an oxide protection layer that covers a surface and a side wall of the stacking structure; separately forming at least one photoresist material blocking portion on the drift layer on two sides of the oxide protection layer; injecting ions to the drift layer by using the oxide protection layer and the photoresist material blocking portion as an ion injection mask layer, to separately form at least two floating regions on the two sides of the fin-shaped channel layer; and removing the oxide protection layer and the photoresist material blocking portion.

Further, after the forming, through deposition, a second insulated isolating layer that covers an external side wall and an upper surface of the gate electrode, the method may further include: forming, at a position corresponding to a region between adjacent floating regions, a groove that penetrates through the first insulated isolating layer and a part of the drift layer; and padding a schottky contact portion in the groove.

According to a third aspect, this application further provides an integrated circuit. The integrated circuit includes a circuit board and a SiC MOSFET that is disposed on the circuit board. The SiC MOSFET may be the SiC MOSFET according to any one of the first aspect or the various implementations of the first aspect, or may be a SiC MOSFET prepared by using the preparation method according to any one of the second aspect or the various implementations of the second aspect.

For technical effects that can be achieved in the third aspect, refer to the description of the technical effects that can be achieved in any possible design of the first aspect. Details are not described herein again.

### BRIEF DESCRIPTION OF THE DRAWINGS

FIG. 1 is a schematic diagram of a structure of a SiC MOSFET according to an embodiment of this application;
FIG. 2 is a schematic diagram of a structure of another SiC MOSFET according to an embodiment of this application;
FIG. 3 is a schematic diagram of a structure of still another SiC MOSFET according to an embodiment of this application;
FIG. 4 is a schematic diagram of a structure of still another SiC MOSFET according to an embodiment of this application;
FIG. 5 is a schematic flowchart of a SiC MOSFET preparation method according to an embodiment of this application;
FIG. 6a to FIG. 6j are schematic diagrams of structures of a process of preparing a SiC MOSFET according to an embodiment of this application;
FIG. 7a to FIG. 7j are schematic diagrams of structures of another process of preparing a SiC MOSFET according to an embodiment of this application; and
FIG. 8a to FIG. 8k are schematic diagrams of structures of still another process of preparing a SiC MOSFET according to an embodiment of this application.

### DETAILED DESCRIPTION

To make the objectives, technical solutions, and advantages of this application clearer, the following further describes this application in detail with reference to the accompanying drawings. However, example implementations may be implemented in a plurality of forms, and should not be understood as being limited to the example implementations described herein. On the contrary, the implementations are provided to make this application more comprehensive and complete, and comprehensively convey the idea of the example implementations to a person skilled in the art. In addition, same reference numerals in the figures represent same or similar structures. Therefore, repeated description thereof is omitted. Expressions of positions and directions in this application are described by using the accompanying drawings as an example. However, changes may be made based on a requirement, and the changes fall within the protection scope of this application. The accompanying drawings in this application are merely used to illustrate a relative position relationship and do not represent a true scale.

It should be noted that specific details are set forth in the following description to facilitate full understanding of this application. However, this application can be implemented in other manners different from those described herein, and a person skilled in the art can make similar inferences without departing from the connotation of this application. Therefore, this application is not limited to the specific implementations disclosed below. Subsequent descriptions in this specification are example implementations of this application, and the descriptions are intended to describe general principles of this application, but are not intended to limit the scope of this application. The protection scope of this application is subject to the appended claims.

To facilitate understanding of a SiC MOSFET provided in embodiments of this application, the following first describes an application scenario of the SiC MOSFET.

Compared with a Si material, a SiC material has advantages such as a large band gap, a high critical breakdown electric field, a high thermal conductivity, and a high electron saturation drift velocity. These characteristics enable a silicon carbide electronic device to work in an environment with a high voltage, high calorific value, and high frequency. Compared with an IGBT prepared by using Si, a MOSFET prepared by using SiC has advantages such as a smaller size, lower power consumption, and better thermal conductivity while proving the same power. Therefore, SiC MOSFETs can be widely used in electric vehicles, charging piles, uninterruptible power supplies, smart grids, and other fields.

Preparation of a gate oxide layer is a key step in production of a SiC MOSFET. At present, a commonly used method is to directly perform high-temperature thermal oxidation on a SiC epitaxial wafer, to form a silicon dioxide gate oxide layer on a surface of the SiC epitaxial wafer. However, numerous interface states exist at a SiC/SiO₂ interface (for example, Si- and C-dangling bonds at the interface, a C-related defect, and an oxide defect near the interface). An interface trap traps carriers in an inversion layer, causing a current density of the device to decrease. Moreover, the trapped carriers generate Coulomb scattering on free carriers in a channel, resulting in low channel mobility and compromising a conduction characteristic of the device. Although nitridation processing may be performed on the interface through subsequent nitrogen and oxygen annealing after the oxidation to improve the channel mobility, the channel mobility is still far lower than that of a silicon carbide body material.

In view of this, embodiments of this application provide a SiC MOSFET and an integrated circuit, which can improve channel mobility and are described in detail in the following with reference to specific accompanying drawings and embodiments.

During specific implementation, two types of carriers exist in a semiconductor, namely holes in a valence band and electrons in a conduction band. A semiconductor that mainly uses electrons for conduction is referred to as an N-type semiconductor, and a semiconductor that mainly uses holes for conduction is referred to as a P-type semiconductor. It should be noted that in this application, in a layer and region prefixed with N or P, a majority of carriers are electrons or holes, respectively. In addition, a plus sign "+" following N or P indicates that the region or layer has a higher doping density than a layer or region not marked with a plus sign "+", and a larger quantity of plus signs "+" indicates a higher doping density. Ns or Ps followed by the same quantity of plus signs "+" mean that the regions or layers have similar doping densities, and do not necessarily have the same doping density.

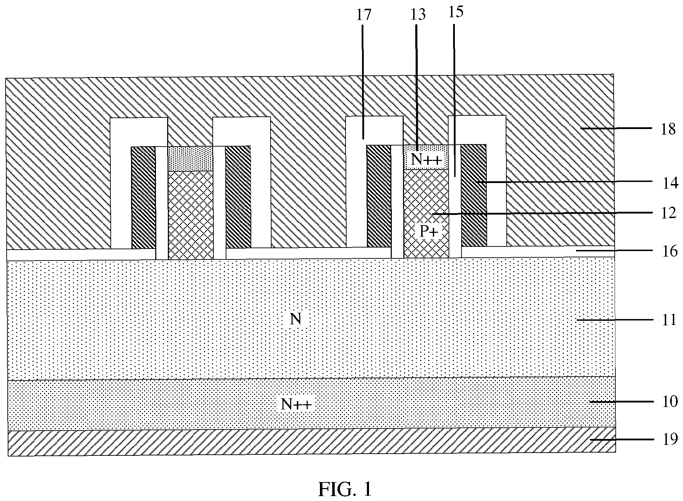

Refer to FIG. 1. FIG. 1 is a schematic diagram of a structure of a SiC MOSFET according to an embodiment of this application. The SiC MOSFET generally may include one or more well regions. In FIG. 1, two well regions are used as an example for illustration. Specifically, the SiC MOSFET may include a SiC semiconductor substrate 10, a drift layer 11, a fin-shaped channel layer 12 (namely a well region), a source region 13, a gate electrode 14, a gate oxide layer 15, a first insulated isolating layer 16, a second insulated isolating layer 17, a source electrode 18, and a drain electrode 19. The drift layer 11 is located on the SiC semiconductor substrate 10, the fin-shaped channel layer 12 is located on the drift layer 11, the source region 13 is located on the fin-shaped channel layer 12, and the first insulated isolating layer 16 is located on a portion that is of the drift layer 11 and that is not covered by the fin-shaped channel layer 12. As the fin-shaped channel layer 12 and the source region 13 are of a stacking structure, the gate electrode 14 is located on the first insulated isolating layer 16 and is located on two sides of the stacking structure, and the gate oxide layer 15 is located between the gate electrode 14 and the stacking structure. The second insulated isolating layer 17 covers an external side wall and an upper surface of the gate electrode 14. The source electrode 18 covers the first insulated isolating layer 16, the second insulated isolating layer 17, and the source region 13. The drain electrode 19 is located on a side that is of the SiC semiconductor substrate 10 and that is away from the drift layer 11. In this way, the first insulated isolating layer 16 is configured to isolate the gate electrode and the drift layer 11. The gate oxide layer 15 is configured to isolate the gate electrode 14 and the fin-shaped channel layer 12, and is configured to isolate the gate electrode 14 and the source region 13. The second insulated isolating layer 17 is configured to isolate the gate electrode 14 and the source electrode 18.

In this application, the fin-shaped channel layer 12 means that the channel layer is of a strip shape, and the gate electrode 14 is located on two sides of the fin-shaped channel layer 12. Therefore, the SiC MOSFET is a Fin FET. Disposing the gate electrode 14 on the two sides of the fin-shaped channel layer 12 is conducive to reducing a width of the fin-shaped channel layer 12 (namely a distance between two gate oxide layers on the two sides of the fin-shaped channel layer 12). This is favorable for global inversion of the fin-shaped channel layer 12, thereby forming a large carrier path in the fin-shaped channel layer 12. In this way, most carriers in the SiC MOSFET flow through an electron path formed in the fin-shaped channel layer 12, so that a quantity of carriers that flow on an edge of the gate oxide layer 15 is reduced, thereby greatly improving channel mobility and also improving reliability of the gate oxide layer 15.

The SiC MOSFET provided in this embodiment of this application may be an NMOS transistor, or may be a PMOS transistor. This is not limited herein. When the SiC MOSFET is an NMOS transistor, the SiC semiconductor substrate 10 may be an N++ region and serves as a drain region, the drift layer 11 may be an N+ region and mainly serves to bear high voltage, the source region 13 may be an N++ region, and the fin-shaped channel layer 12 may be a P region, namely a P-well. A P-well is a region that is on an N-type semiconductor layer and that is doped with a P-type impurity of a density high enough to neutralize the N-type semiconductor layer and make the N-type semiconductor layer have a P-type characteristic. When the SiC MOSFET is a PMOS transistor, the SiC semiconductor substrate 10 may be a P++ region and serves as a drain region, the drift layer 11 may be a P+ region and mainly serves to bear high voltage, the source region 13 may be a P++ region, and the fin-shaped channel layer 12 may be an N region, namely an N-well. An N-well is a region that is on a P-type semiconductor layer and that is doped with an N-type impurity of a density high enough to neutralize the P-type semiconductor layer and make the P-type semiconductor layer have an N-type characteristic. During specific implementation, the SiC MOSFET is generally an NMOS transistor because hole mobility is lower than electron mobility. This is not limited herein.

It should be noted that, as an example for illustration in both the specification and accompanying drawings of this application, the SiC MOSFET is an NMOS transistor. For a case in which the SiC MOSFET is a PMOS transistor, an N region in the NMOS transistor may be replaced with a P region, and a P region in the NMOS transistor may be replaced with an N region.

In this application, an N-type semiconductor region is mainly doped with an N-type impurity, such as phosphorus (P) or nitrogen (N). A P-type semiconductor region is mainly doped with a P-type impurity, such as aluminum (Al), boron (B), gallium (Ga), or beryllium (Be).

During actual application, a high electric field exists in a drift region when the SiC MOSFET is in a blocked state, and a curvature effect exists at a bottom part of the fin-shaped channel layer 12, causing an especially centralized electric field beneath the gate oxide layer 15. Long-standing high electric field stress causes quality degradation of the gate oxide layer 15, compromising reliability of the device.

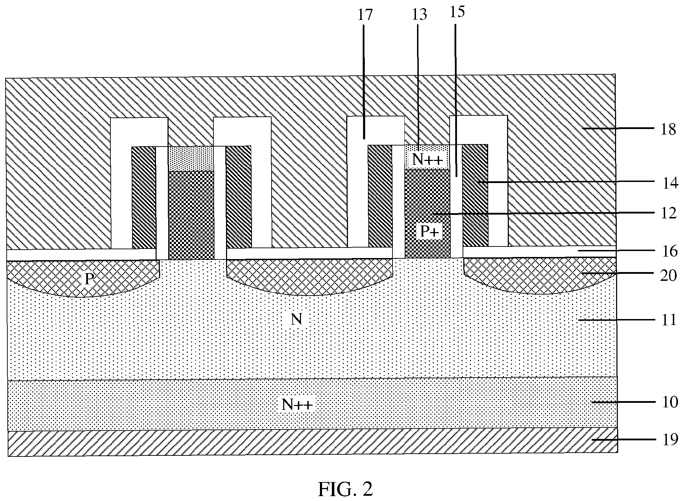

Therefore, for example, refer to FIG. 2. FIG. 2 is a schematic diagram of a structure of a SiC MOSFET according to another embodiment of this application. For example, the SiC MOSFET may further include a floating (Floating) region 20 that is located on the drift layer 11 and that is separately located on the two sides of the fin-shaped channel layer 12. In this way, an electric field strength beneath the gate oxide layer 15 can be weakened, thereby protecting the gate oxide layer 15 and greatly improving gate reliability of the device.

During specific implementation, when the SiC MOSFET is an NMOS transistor, the floating region 20 is a P-type semiconductor region. When the SiC MOSFET is a PMOS transistor, the floating region 20 is an N-type semiconductor region. A doping density of the floating region 20 is generally lower than a doping density of the fin-shaped channel layer 12.

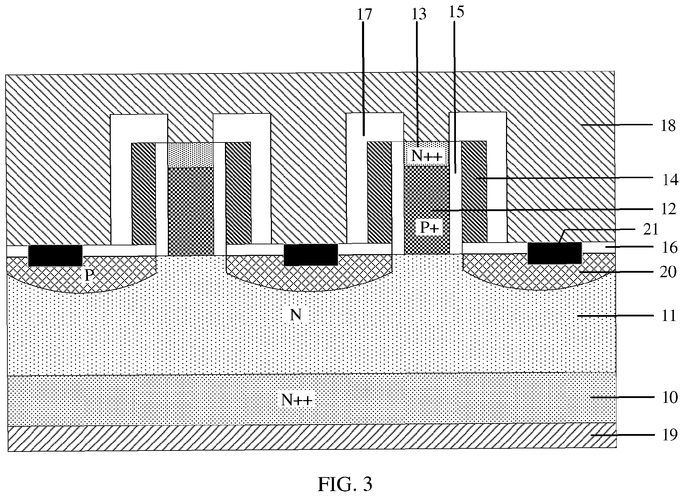

Further, to implement reverse parallel connection of a flyback diode inside the device, refer to FIG. 3. FIG. 3 is a schematic diagram of a structure of a SiC MOSFET according to still another embodiment of this application. The SiC MOSFET may further include: a groove that is located on the two sides of the fin-shaped channel layer 12 and that penetrates through the first insulated isolating layer 16 and a part of the floating region 20; and an ohmic contact portion 21 that is padded in the groove. The source electrode 18 is electrically connected to the floating region 20 through the ohmic contact portion 21.

In this application, the ohmic contact portion may be formed by using any material that can form ohmic contact with the floating region 20. This is not limited herein.

During specific implementation, a SiC MOSFET may have a bipolar degradation effect. This effect is mainly triggered by basal plane dislocation previously existing on SiC crystal. During bipolar operation, energy released by combination of electrons and holes causes a stacking fault to spread at a position of the basal plane dislocation. The stacking fault spreads to a surface of a semiconductor material and then stops spreading. A region covered by an expanded stacking fault is no longer conductive. Therefore, an effective active region of the SiC MOSFET is reduced.

To avoid a bipolar degradation effect for the SiC MOSFET, a schottky barrier diode (Schottky Barrier Diode, SBD) may be reversely connected in parallel to the SiC MOSFET to implement reverse flyback, thereby avoiding the bipolar degradation effect. However, an external SBD connected in parallel inevitably increases packaging costs and stray inductance, causing degradation of a switching characteristic of the device.

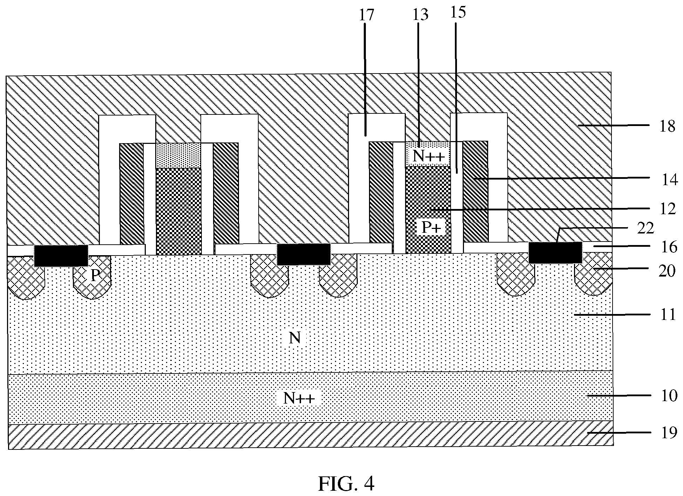

Therefore, in this application, to avoid a bipolar degradation effect for the SiC MOSFET, a schottky barrier diode is integrated inside the SiC MOSFET, to improve a reverse conduction characteristic and a switching characteristic. For example, refer to FIG. 4. FIG. 4 is a schematic diagram of a structure of a SiC MOSFET according to still another embodiment of this application. In the SiC MOSFET, at least two spaced floating regions 20 are separately disposed on the two sides of the fin-shaped channel layer 12. The SiC MOSFET may further include: a groove that is located on the two sides of the fin-shaped channel layer 12 and that penetrates through the first insulated isolating layer 16 and a part of the drift layer 11, where the groove is located between adjacent floating regions 20; and a schottky contact portion 22 that is padded in the groove.

During specific implementation, the schottky contact portion 22 may be formed by using any material that can form schottky contact with the drift layer 11. This is not limited herein. For example, the schottky contact portion 22 may be formed by using alloy. This is not limited herein.

During specific implementation, a material of the gate electrode in this application may be a polycrystalline silicon material, or may be another material that has a good electric conduction characteristic, such as metal. This is not limited herein.

For example, the gate electrode in the SiC MOSFET is generally formed by using polycrystalline silicon.

It should be noted that in this application, comparison between doping densities of two regions is merely comparison between densities of impurities doped in these two regions, and components of the impurities are not limited. In other words, the components of the impurities may be the same or may be different. A material of a substrate to which the impurities are doped is SiC.

In an embodiment, the drift layer 11, the fin-shaped channel layer 12, and the source region 13 may be formed by performing ion doping on a SiC material that is grown through epitaxy. The gate oxide layer 15 and the first insulated isolating layer 16 are SiOi formed by performing thermal oxidation on a SiC material. A material of the second insulated isolating layer 17 may be at least one of silicon oxide and silicon nitride.

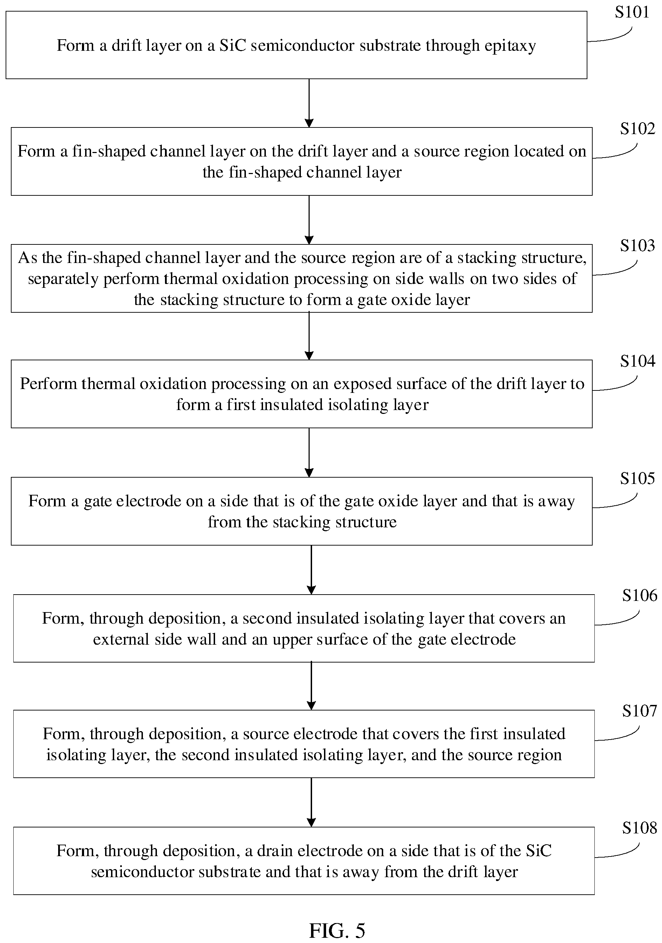

Refer to FIG. 5. FIG. 5 is a schematic flowchart of a SiC MOSFET preparation method according to an embodiment of this application. The preparation method may include the following steps.

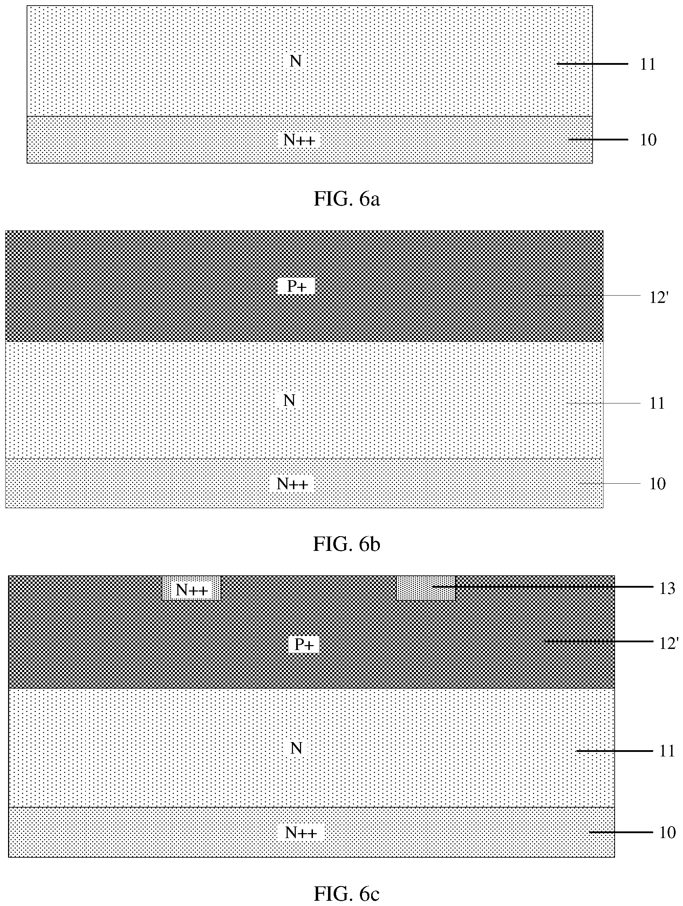

Step S101: As shown in FIG. 6a, form a drift layer 11 on a SiC semiconductor substrate 10 through epitaxy.

For example, the SiC semiconductor substrate 10 may be an N-type semiconductor. During specific implementation, SiC may be first formed on the SiC semiconductor substrate through epitaxy, and then N-type ions are injected to the SiC to form the drift layer.

Step S102: Form a fin-shaped channel layer on the drift layer and a source region located on the fin-shaped channel layer.

As shown in FIG. 6b, a channel layer 12' may be grown on the drift layer 11 through epitaxy. For example, the channel layer 12' may be SiC doped with P-type ions.

As shown in FIG. 6c, ion injection is performed on a region that is of the channel layer 12' and that is close to a surface, to form a source region 13. For example, N-type ions may be injected only to a corresponding region on which the fin-shaped channel layer is to be formed, to form the source region 13.

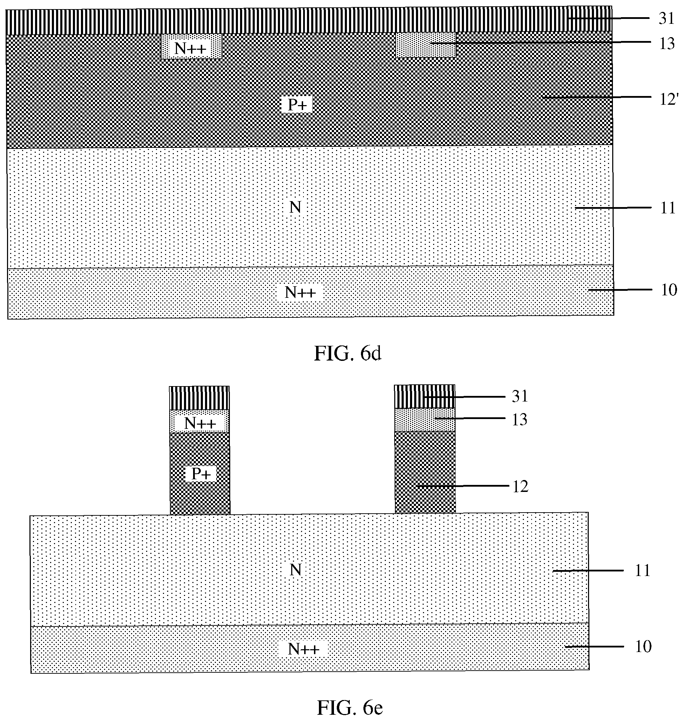

As shown in FIG. 6d, a nitride layer 31 is formed on the channel layer 12'. A purpose of the nitride layer 31 is to prevent an upper surface of the source region from oxidation when a gate oxide layer is formed.

As shown in FIG. 6e, etching is performed on the channel layer 12' and the nitride layer 31 to form the fin-shaped channel layer 12 and the source region 13 located on the fin-shaped channel layer 12, and the nitride layer 31 located on the source region 13 is retained.

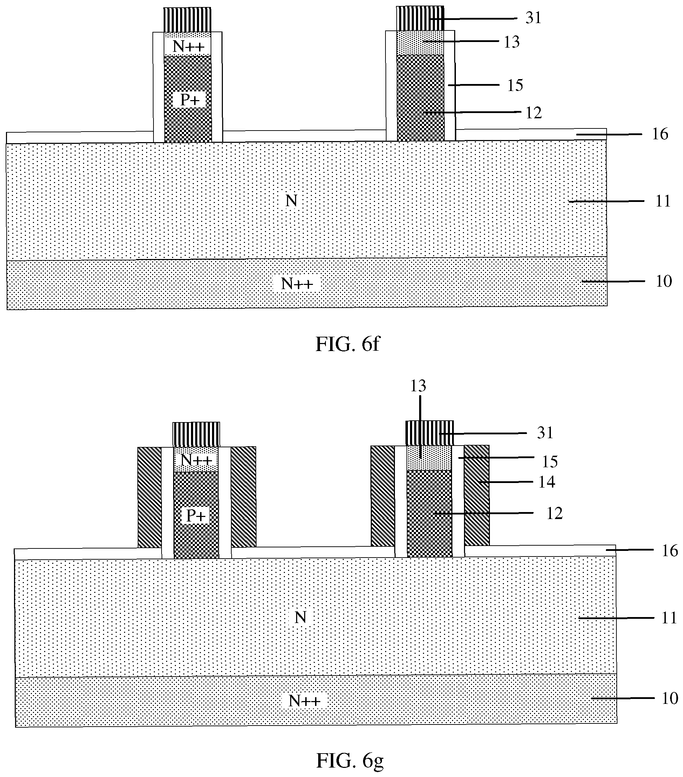

Step S103: As shown in FIG. 6f, as the fin-shaped channel layer 12 and the source region 13 are of a stacking structure, separately perform thermal oxidation processing on side walls on two sides of the stacking structure to form a gate oxide layer 15.

Step S104: As shown in FIG. 6f, perform thermal oxidation processing on an exposed surface of the drift layer 11 to form a first insulated isolating layer 16.

For example, step S 103 and step S 104 may be performed at the same time.

Step S105: As shown in FIG. 6g, form a gate electrode 14 on a side that is of the gate oxide layer 15 and that is away from the stacking structure.

For example, a material of the gate electrode 14 may be a polycrystalline silicon material. This is not limited herein.

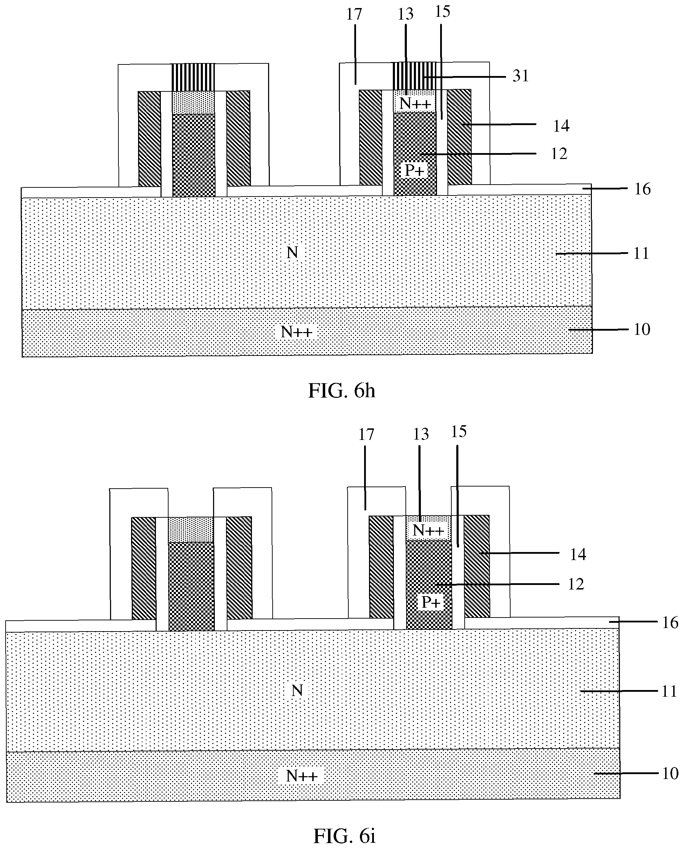

Step S106: As shown in FIG. 6h, form, through deposition, a second insulated isolating layer 17 that covers an external side wall and an upper surface of the gate electrode 14.

For example, the second insulated isolating layer 17 may be formed by using at least one of silicon oxide and silicon nitride. This is not limited herein.

Optionally, as shown in FIG. 6i, the nitride layer 31 located on the source region 13 is removed.

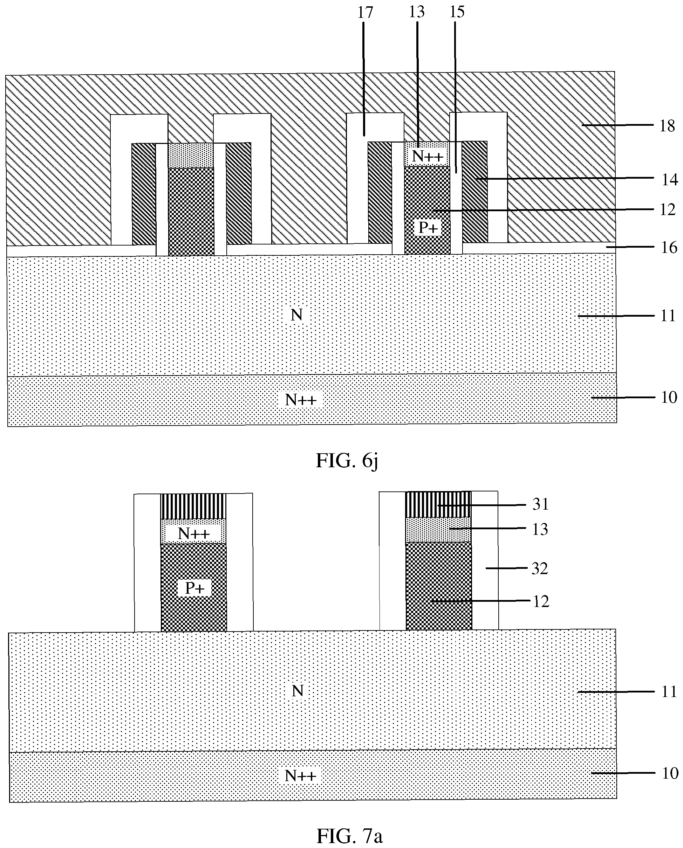

Step S107: As shown in FIG. 6j, form, through deposition, a source electrode 18 that covers the first insulated isolating layer 16, the second insulated isolating layer 17, and the source region 13.

For example, the source electrode may be formed by using a conductive material, such as metal.

Step S108: Form, through deposition, a drain electrode 19 on a side that is of the SiC semiconductor substrate 10 and that is away from the drift layer 11, to form the SiC MOSFET as shown in FIG. 1.

For example, the drain electrode may be formed by using a conductive material, such as metal.

It should be noted that in this application, step S108 may alternatively be performed before any one of step S101 to step S107. This is not limited herein.

Optionally, in this application, before thermal oxidation processing is separately performed on the side walls on the two sides of the stacking structure to form the gate oxide layer in step S103, the method may further include: forming, through deposition, an oxide protection layer that covers a surface and a side wall of the stacking structure; injecting ions to the drift layer by using the oxide protection layer as an ion injection mask layer, to separately form a floating region on two sides of the channel layer; and removing the oxide protection layer.

The following describes this application in detail by using an N-type SiC MOSFET as an example in combination with specific embodiments. It should be noted that this embodiment is intended for better explaining the present invention, rather than limiting this application. To facilitate understanding of a field-effect transistor provided in embodiments of this application, the following describes a field-effect transistor preparation method with reference to accompanying drawings.

In an embodiment of this application, with reference to FIG. 6a to FIG. 6e and FIG. 7a to FIG. 7j, a SiC MOSFET may be prepared by using the following preparation method. The method includes the following steps.

Step S201: As shown in FIG. 6a, form a drift layer 11 on a SiC semiconductor substrate 10 through epitaxy.

Step S202: As shown in FIG. 6b, grow a channel layer 12' on the drift layer 11 through epitaxy.

Step S203: As shown in FIG. 6c, inject N-type ions into a region that is of the channel layer 12' and that is close to a surface, to form a source region 13.

Step S204: As shown in FIG. 6d, form a nitride layer 31 on the channel layer 12'.

Step S205: As shown in FIG. 6e, etch on the channel layer 12' and the nitride layer 31 to form a fin-shaped channel layer 12 and a source region 13 located on the fin-shaped channel layer 12, and retain the nitride layer 31 located on the source region 13.

Step S206: As shown in FIG. 7a, form, through deposition, an oxide protection layer 32 that covers a surface and a side wall of a stacking structure.

For example, a material of the oxide protection layer 32 may be silicon dioxide. A purpose of the oxide protection layer 32 is to prevent a floating region from subsequently diffusing to beneath the fin-shaped channel layer 12.

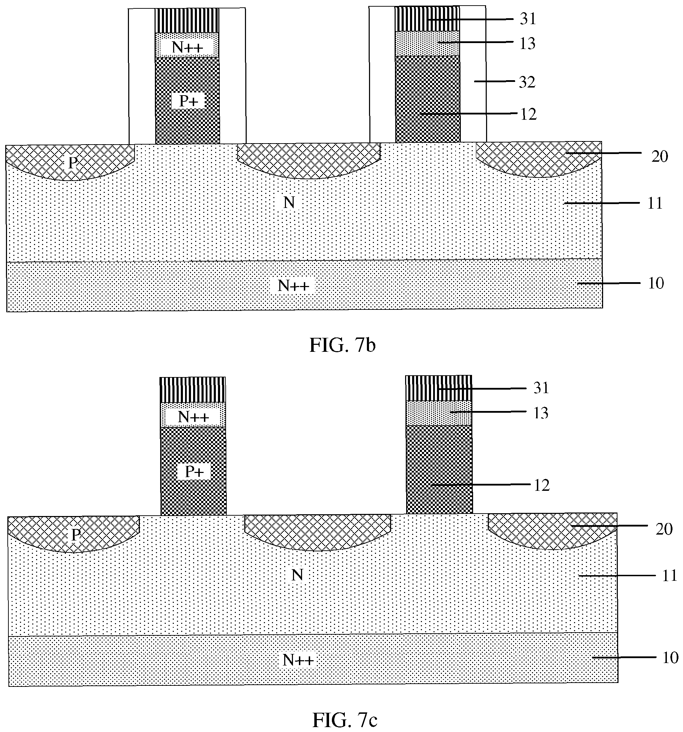

Step S207: As shown in FIG. 7b, inject P-type ions to the drift layer 11 by using the oxide protection layer 32 as an ion injection mask layer, to separately form a floating region 20 on two sides of the fin-shaped channel layer 12.

Using the oxide protection layer 32 as the ion injection mask layer can save a mask for preparing the floating region.

Step S208: As shown in FIG. 7c, remove the oxide protection layer 32.

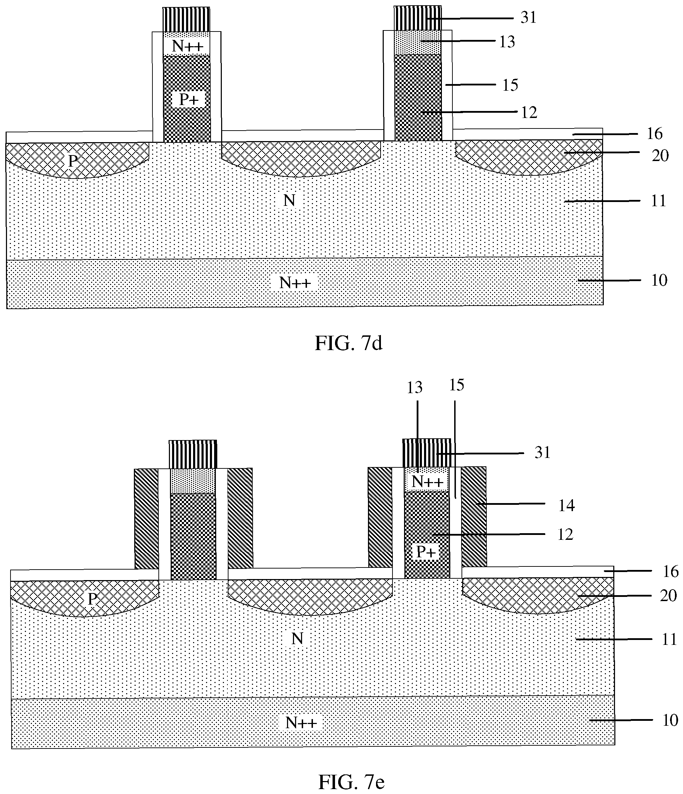

Step S209: As shown in FIG. 7d, as the fin-shaped channel layer 12 and the source region 13 are of a stacking structure, separately perform thermal oxidation processing on side walls on two sides of the stacking structure to form a gate oxide layer 15; and perform thermal oxidation processing on an exposed surface of the drift layer 11 to form a first insulated isolating layer 16.

Step S210: As shown in FIG. 7e, form a gate electrode 14 on a side that is of the gate oxide layer 15 and that is away from the stacking structure.

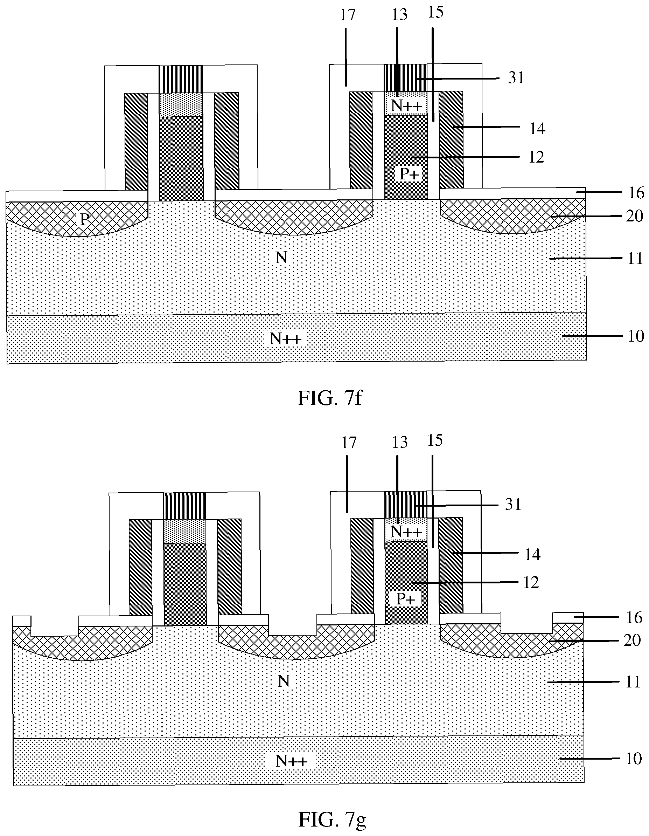

Step S211: As shown in FIG. 7f, form, through deposition, a second insulated isolating layer 17 that covers an external side wall and an upper surface of the gate electrode 14.

Step S212: As shown in FIG. 7g, form a groove that penetrates through the first insulated isolating layer 16 and a part of the floating region 20.

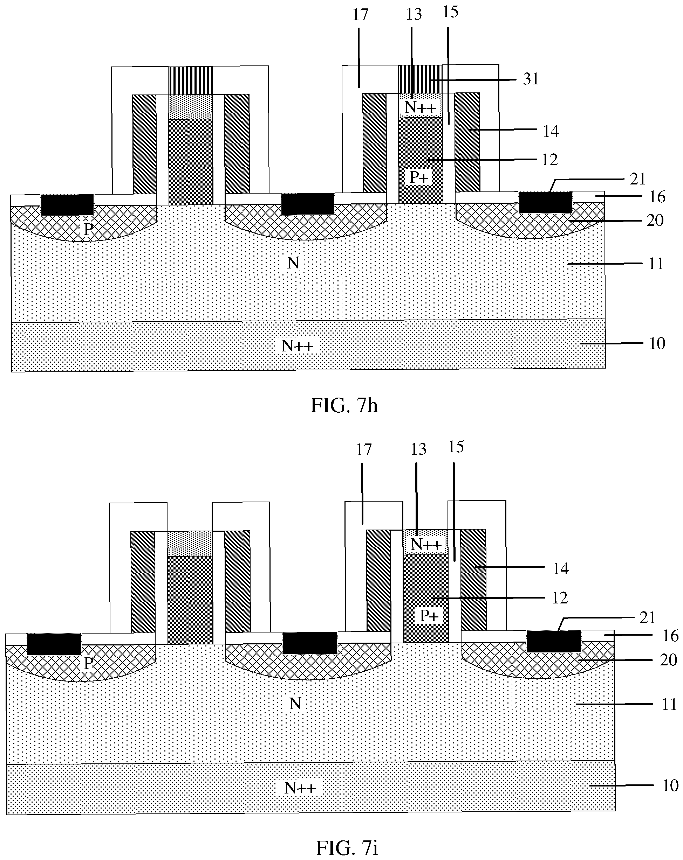

Step S213: As shown in FIG. 7h, pad an ohmic contact portion 21 in the groove.

Step S214: as shown in FIG. 7i, remove the nitride layer 31 located on the source region 13.

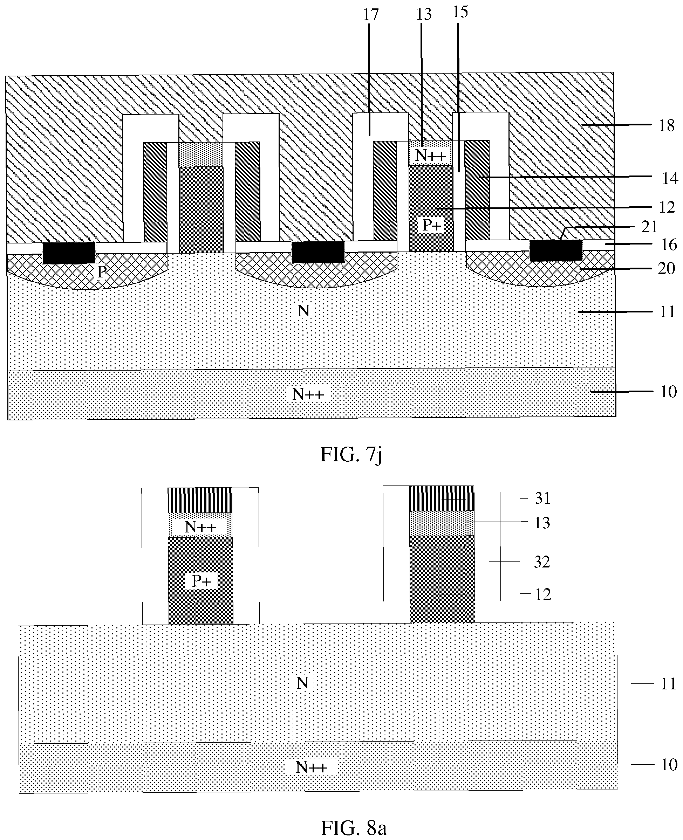

Step S215: As shown in FIG. 7j, form, through deposition, a source electrode 18 that covers the first insulated isolating layer 16, the second insulated isolating layer 17, and the source region 13.

Step S216: Form, through deposition, a drain electrode 19 on a side that is of the SiC semiconductor substrate 10 and that is away from the drift layer 11, to form the SiC MOSFET as shown in FIG. 3.

In another embodiment of this application, with reference to FIG. 6a to FIG. 6e and FIG. 8a to FIG. 8k, a SiC MOSFET may be prepared by using the following preparation method. The method includes the following steps.

Step S301: As shown in FIG. 6a, form a drift layer 11 on a SiC semiconductor substrate 10 through epitaxy.

Step S302: As shown in FIG. 6b, grow a channel layer 12' on the drift layer 11 through epitaxy.

Step S303: As shown in FIG. 6c, inject N-type ions into a region that is of the channel layer 12' and that is close to a surface, to form a source region 13.

Step S304: As shown in FIG. 6d, form a nitride layer 31 on the channel layer 12'.

Step S305: As shown in FIG. 6e, etch on the channel layer 12' and the nitride layer 31 to form a fin-shaped channel layer 12 and a source region 13 located on the fin-shaped channel layer 12, and retain the nitride layer 31 located on the source region 13.

Step S306: As shown in FIG. 8a, form, through deposition, an oxide protection layer 32 that covers a surface and a side wall of a stacking structure.

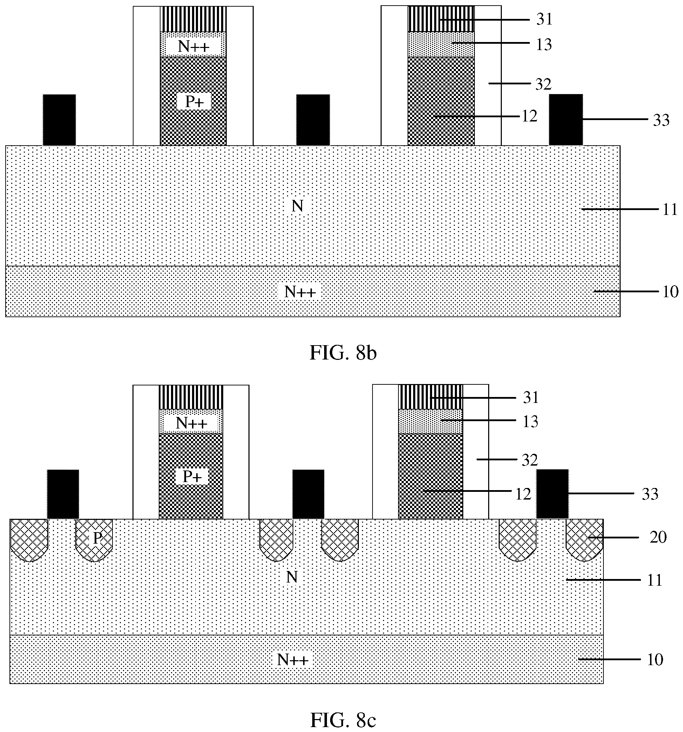

Step S307: As shown in FIG. 8b, separately form at least one photoresist material blocking portion 33 on the drift layer 11 on two sides of the oxide protection layer 32.

During specific implementation, a quantity of photoresist material blocking portions 33 on each side of the stacking structure may be determined based on a quantity of floating regions to be formed on the side of the stacking structure. For example, if n floating regions need to be formed on the side of the stacking structure, n-1 photoresist material blocking portions 33 need to be formed on the side, where n is an integer greater than 1.

Step S308: As shown in FIG. 8c, inject P-type ions to the drift layer by using the oxide protection layer 32 and the photoresist material blocking portion 33 as an ion injection mask layer, to separately form at least two floating regions 20 on the two sides of the fin-shaped channel layer 12.

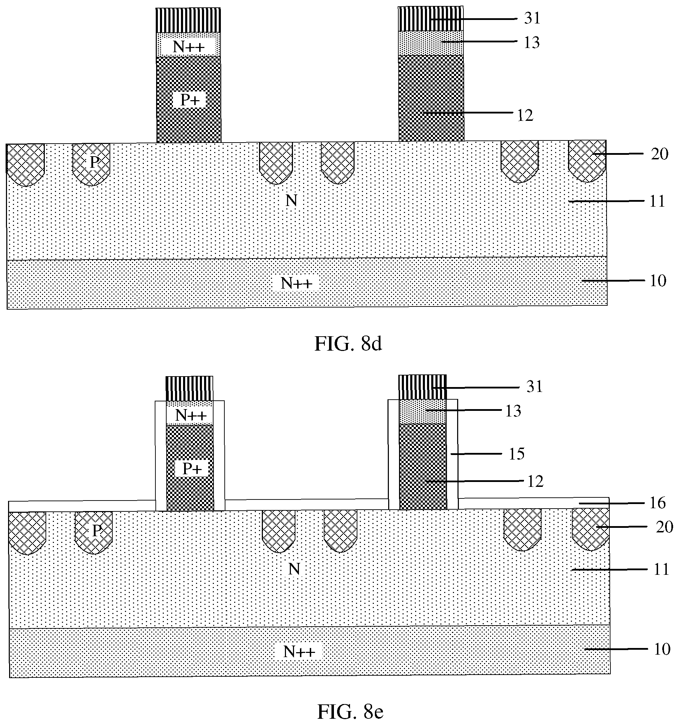

Step S309: As shown in FIG. 8d, remove the photoresist material blocking portion and the oxide protection layer 32.

Step S310: As shown in FIG. 8e, as the fin-shaped channel layer 12 and the source region 13 are of a stacking structure, separately perform thermal oxidation processing on side walls on two sides of the stacking structure to form a gate oxide layer 15; and perform thermal oxidation processing on an exposed surface of the drift layer 11 to form a first insulated isolating layer 16.

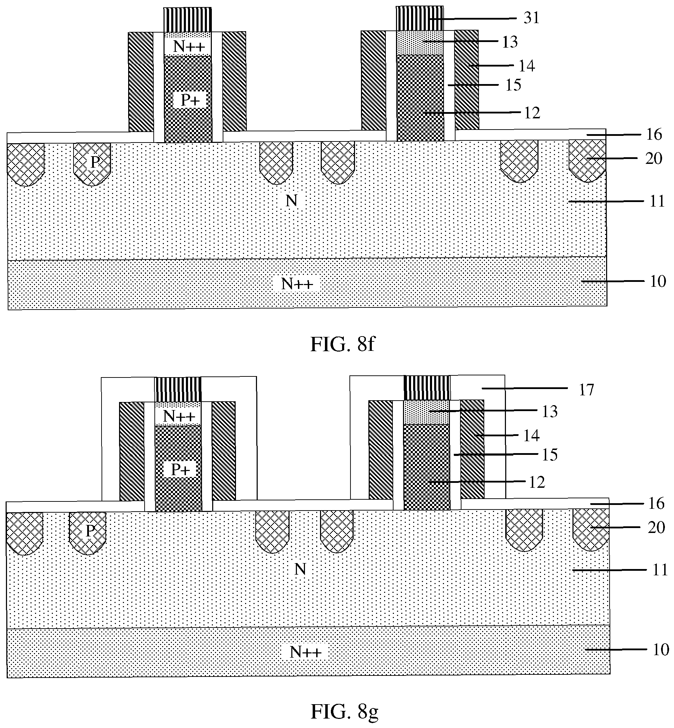

Step S311: As shown in FIG. 8f, form a gate electrode 14 on a side that is of the gate oxide layer 15 and that is away from the stacking structure.

Step S312: As shown in FIG. 8g, form, through deposition, a second insulated isolating layer 17 that covers an external side wall and an upper surface of the gate electrode 14.

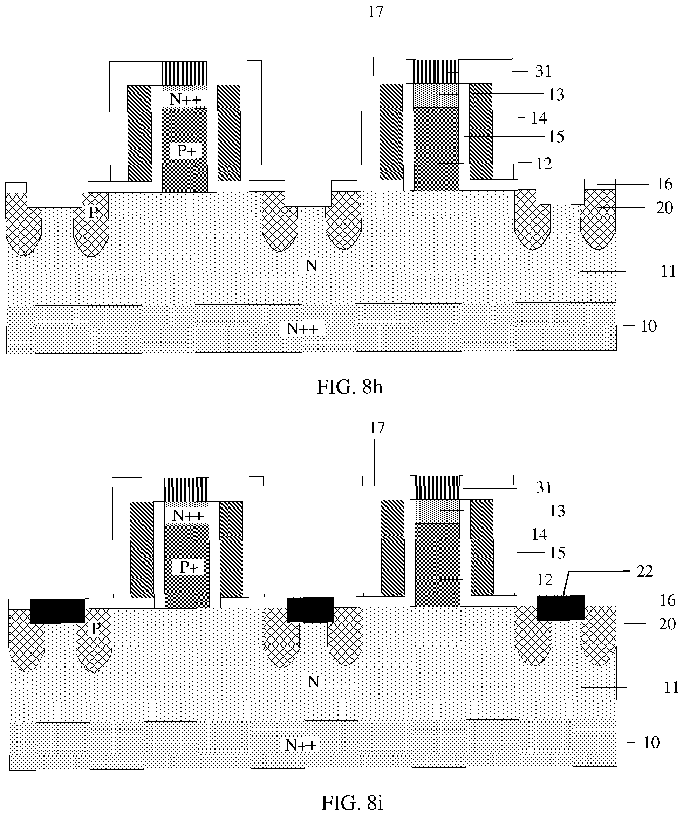

Step S313: As shown in FIG. 8h, form, at a position corresponding to a region between adjacent floating regions, a groove that penetrates through the first insulated isolating layer and a part of the drift layer.

Step S314: As shown in FIG. 8i, pad a schottky contact portion 22 in the groove.

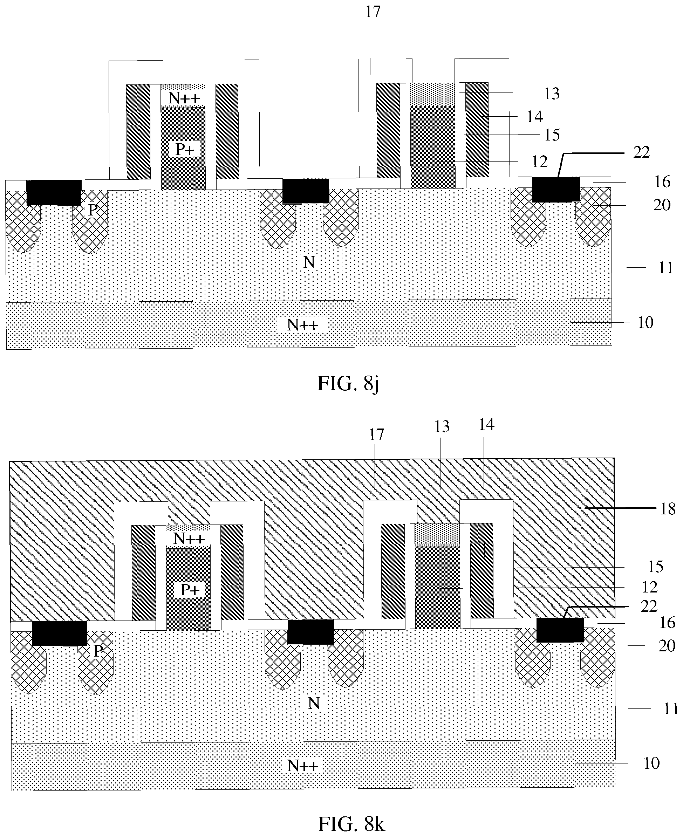

Step S315: As shown in FIG. 8j, remove the nitride layer 31 located on the source region 13.

Step S316: As shown in FIG. 8k, form, through deposition, a source electrode 18 that covers the first insulated isolating layer 16, the second insulated isolating layer 17, and the source region 13.

Step S317: Form, through deposition, a drain electrode 19 on a side that is of the SiC semiconductor substrate 10 and that is away from the drift layer 11, to form the SiC MOSFET as shown in FIG. 4.

In the SiC MOSFET provided in this embodiment of this application, the gate electrode 14 is located on two sides of the fin-shaped channel layer 12. Therefore, the SiC MOSFET is a Fin FET. Disposing the gate electrode 14 on the two sides of the fin-shaped channel layer 12 is conducive to reducing a width of the fin-shaped channel layer 12. This is favorable for global inversion of the fin-shaped channel layer, thereby forming a large carrier path in the fin-shaped channel layer 12. In this way, most carriers in the SiC MOSFET flow through an electron path formed in the fin-shaped channel layer 12, so that a quantity of carriers that flow on an edge of the gate oxide layer 15 is reduced, thereby greatly improving channel mobility and also improving reliability of the gate oxide layer 15. Further, in the SiC MOSFET, the floating regions 20 are disposed on the drift layer 11, so that an electric field strength beneath the gate oxide layer 15 can be weakened, thereby protecting the gate oxide layer 15 and greatly improving gate reliability of the device. In addition, in this application, a schottky barrier diode is integrated inside the SiC MOSFET. This can avoid a bipolar degradation effect for the SiC MOSFET, thereby improving a reverse conduction characteristic and a switching characteristic.

Correspondingly, an embodiment of this application further provides an integrated circuit. The integrated circuit may include a circuit board and any SiC MOSFET provided in the foregoing embodiments of this application. The SiC MOSFET is disposed on the circuit board. A problem solving principle of the electronic circuit is similar to that of a SiC MOSFET described above. Therefore, for implementations of the electronic circuit, refer to implementations of the SiC MOSFET. Repeated content is not described herein again.

Obviously, a person skilled in the art can make various modifications and variations to this application without departing from the spirit and scope of this application. Therefore, this application is intended to cover these modifications and variations of this application provided that they fall within the scope of protection defined by the claims of this application and their equivalent technologies.

## Claims

1. A SiC metal-oxide-semiconductor field-effect transistor (Metal-Oxide-Semiconductor Field-Effect Transistor, MOSFET), comprising:
a SiC semiconductor substrate;
a drift layer located on the SiC semiconductor substrate;
a fin-shaped channel layer located on the drift layer;
a source region located on the fin-shaped channel layer; and
a first insulated isolating layer located on a portion that is of the drift layer and that is not covered by the fin-shaped channel layer, wherein
as the fin-shaped channel layer and the source region are of a stacking structure, the SiC MOSFET further comprises:
a gate electrode that is located on the first insulated isolating layer and that is separately located on two sides of the stacking structure;
a gate oxide layer located between the gate electrode and the stacking structure;
a second insulated isolating layer that covers an external side wall and an upper surface of the gate electrode;
a source electrode that covers the first insulated isolating layer, the second insulated isolating layer, and the source region; and
a drain electrode located on a side that is of the SiC semiconductor substrate and that is away from the drift layer.

2. The SiC MOSFET according to claim 1, wherein the SiC MOSFET further comprises a floating region that is located on the drift layer and that is separately located on two sides of the fin-shaped channel layer.

3. The SiC MOSFET according to claim 2, wherein the SiC MOSFET further comprises:
a groove that is located on the two sides of the fin-shaped channel layer and that penetrates through the first insulated isolating layer and a part of the floating region; and
an ohmic contact portion that is padded in the groove.

4. The SiC MOSFET according to claim 2, wherein at least two spaced floating regions are separately disposed on the two sides of the fin-shaped channel layer, and the SiC MOSFET further comprises:
a groove that is located on the two sides of the fin-shaped channel layer and that penetrates through the first insulated isolating layer and a part of the drift layer, wherein the groove is located between adjacent floating regions; and
a schottky contact portion that is padded in the groove.

5. The SiC MOSFET according to any one of claims 1 to 4, wherein a material of the gate electrode is polycrystalline silicon.

6. A SiC MOSFET preparation method, comprising:
forming a drift layer on a SiC semiconductor substrate through epitaxy;
forming a fin-shaped channel layer on the drift layer and a source region located on the fin-shaped channel layer;
as the fin-shaped channel layer and the source region are of a stacking structure, separately performing thermal oxidation processing on side walls on two sides of the stacking structure to form a gate oxide layer;
performing thermal oxidation processing on an exposed surface of the drift layer to form a first insulated isolating layer;
forming a gate electrode on a side that is of the gate oxide layer and that is away from the stacking structure;
forming, through deposition, a second insulated isolating layer that covers an external side wall and an upper surface of the gate electrode;
forming, through deposition, a source electrode that covers the first insulated isolating layer, the second insulated isolating layer, and the source region; and
forming, through deposition, a drain electrode on a side that is of the SiC semiconductor substrate and that is away from the drift layer.

7. The preparation method according to claim 6, wherein the forming a fin-shaped channel layer on the drift layer and a source region located on the fin-shaped channel layer comprises:
growing a channel layer on the drift layer through epitaxy;
performing ion injection on a region that is of the channel layer and that is close to a surface, to form a source region;
forming a nitride layer on the channel layer; and
etching on the channel layer and the nitride layer to form the fin-shaped channel layer and the source region located on the fin-shaped channel layer, and retaining the nitride layer located on the source region, wherein
the preparation method further comprises: removing the nitride layer located on the source region after forming, through deposition, an isolating oxide layer that covers the external side wall and the upper surface of the gate electrode and an upper surface of the drift layer.

8. The preparation method according to claim 7, before the separately performing thermal oxidation processing on side walls on two sides of the stacking structure to form a gate oxide layer, further comprising:
forming, through deposition, an oxide protection layer that covers a surface and a side wall of the stacking structure;
injecting ions to the drift layer by using the oxide protection layer as an ion injection mask layer, to separately form a floating region on two sides of the fin-shaped channel layer; and
removing the oxide protection layer.

9. The preparation method according to claim 8, after the forming, through deposition, a second insulated isolating layer that covers an external side wall and an upper surface of the gate electrode, further comprising:
forming a groove that penetrates through the first insulated isolating layer and a part of the floating region; and
padding an ohmic contact portion in the groove.

10. The preparation method according to claim 8, after the forming, through deposition, an oxide protection layer that covers a surface and a side wall of the stacking structure, further comprising:
separately forming at least one photoresist material blocking portion on the drift layer on two sides of the oxide protection layer; and
the injecting ions to the drift layer by using the oxide protection layer as an ion injection mask layer, to separately form a floating region on two sides of the fin-shaped channel layer comprises:
injecting ions to the drift layer by using the oxide protection layer and the photoresist material blocking portion as an ion injection mask layer, to separately form at least two floating regions on the two sides of the fin-shaped channel layer; and removing the photoresist material blocking portion.

11. The preparation method according to claim 10, after the forming, through deposition, a second insulated isolating layer that covers an external side wall and an upper surface of the gate electrode, further comprising:
forming, at a position corresponding to a region between adjacent floating regions, a groove that penetrates through the first insulated isolating layer and a part of the drift layer; and
padding a schottky contact portion in the groove.

12. An integrated circuit, comprising a circuit board and a SiC MOSFET that is disposed on the circuit board, wherein the SiC MOSFET is the SiC MOSFET according to any one of claims 1 to 5, or the SiC MOSFET is formed by using the preparation method according to any one of claims 6 to 11.
